# EUROPEAN PATENT SPECIFICATION

(11) **EP 1 626 616 B1**
(45) Date of publication and mention of the grant of the patent: **31.01.2007**
(21) Application number: 05015217.2
(22) Date of filing: 13.07.2005
(51) Int. Cl.: H05K 7/20

(54) **Engine control circuit device**
Steuerschaltung eines Motors
Circuit de commande pour un moteur

(30) Priority: 13.07.2004 JP 2004206218
(43) Date of publication of application: 15.02.2006
(73) Proprietor: Hitachi, Ltd., Tokyo 100-8280 (JP)
(72) Inventor: Kadoya, Kiyoomi c/o Hitachi, Ltd., Int. Prop. Gp., Chiyoda-ku Tokyo 100-8220 (JP); Eguchi, Shuuji c/o Hitachi, Ltd., Int. Prop. Gp., Chiyoda-ku Tokyo 100-8220 (JP); Sasaki, Masahiro c/o Hitachi, Ltd., Int. Prop. Gp., Chiyoda-ku Tokyo 100-8220 (JP); Mayuzumi, Takuya c/o Hitachi, Ltd., Int. Prop. Gp., Chiyoda-ku Tokyo 100-8220 (JP)
(74) Representative: Beetz & Partner

(56) References cited:
- WO-A-03/065469
- GB-A- 1 587 998
- US-B1- 6 282 092
- US-B1- 6 367 544

## Description

### BACKGROUND OF THE INVENTION

### 1. Field of the Invention

The present invention relates to a circuit device comprising a circuit board on which a plurality of packaged electronic parts are mounted, and a connector mounted on the circuit board for connection to an external circuit. More particularly, the present invention relates to an engine control circuit device for use in automobiles, ships, agricultural machines, engineering machines, and so on.

### 2. Description of the Related Art

Recently, thermal environments of a module for controlling engines used in automobiles, ships, agricultural machines, engineering machines, etc. (hereinafter such a module is referred to as an "engine control circuit device") have become increasingly severe year by year. In other words, the installation place of the engine control circuit device has changed from a compartment to an engine room and then to a location on an engine itself (called "on-engine mounting"). Correspondingly, the engine control circuit device has been exposed to higher temperatures. Further, the amount of generated heat has increased with a larger current supplied to a control load, and the amount of heat generated per unit volume has also increased with downsizing of the device.

Generally, an engine control circuit device had a waterproof structure comprising a circuit board on which a plurality of packaged electronic parts are mounted, and a housing covering the circuit board. To be adapted for the above-mentioned mounting of the circuit device in the engine room, however, it has become more prevail to use a housing with both a heat radiating structure and a waterproof structure. Further, in the case of the on-engine mounting where the engine control circuit device is subjected to severer thermal environments, the circuit device is required to have thermal resistance against temperatures of not lower than 130°C.

As one example of the related art, an electronic circuit device is disclosed which comprises a metal substrate including electronic parts mounted on one surface of the metal substrate, a case provided with heat radiating fins and accommodating the electronic parts therein with the metal substrate serving as a cover, and a resin filled between the metal substrate and the case (see, e.g., Patent Reference 1; JP,A 11-354956). According to the disclosed electronic circuit device, heat is radiated from both of the heat radiating fins of the case and the other surface of the metal substrate on which no electronic parts are mounted (i.e., an installation surface of the electronic circuit device).

### SUMMARY OF THE INVENTION

However, the related art has the following problem.

In the disclosed electronic circuit device, though not clearly stated in Patent Reference 1, the resin filled between the metal substrate and the case is presumably a thermoplastic resin (for the reason that, if a thermo-setting resin is filled, the resin must be injected under high pressure and the case may be damaged). A versatile thermoplastic resin has a linear thermal expansion coefficient of about 50 ppm/°C, for example, and therefore causes a large difference in linear thermal expansion coefficient relative to a circuit board (metal substrate), the electronic parts, and other structural members. Because of such a large difference, the electronic parts may be damaged with thermal expansion under actual environments. On the other hand, an attempt of reducing the linear thermal expansion coefficient of the thermoplastic resin pushes up the cost.

Accordingly, it is an object of the present invention to provide an engine control circuit device that has higher heat resistance and can be installed in a place exposed to severe thermal environments.

To achieve the above object, the present invention provides an engine control circuit device comprising a circuit board on which a plurality of packaged electronic parts are mounted, and a connector mounted on the circuit board for connection to an external circuit, wherein the engine control circuit device further comprises a resin portion formed of a thermo-setting resin and covering the connector except for a connecting portion thereof and the circuit board; and a cooling means integrally molded in the resin portion and cooling the resin portion.

According to the present invention, since the circuit board including the plurality of electronic parts and the connector mounted thereon is covered with the thermo-setting resin having good heat conductance, heat radiation from the electronic parts can be increased. Further, since the resin portion is cooled by the cooling means that is integrally molded in the resin portion, the entirety of the engine control circuit device including the electronic parts can be efficiently cooled. In addition, the linear thermal expansion coefficient of the thermo-setting resin is generally lower than that of a thermoplastic resin, and can be set closer to the linear thermal expansion coefficient of the circuit board, the electronic parts and other structural members. This is effective in suppressing damages of the electronic parts, which is attributable to thermal expansion. It is therefore possible to increase heat resistance of the engine control circuit device and to install the device in a place exposed to severe thermal environments.

Preferably, the cooling means is a cooling pipe through which a coolant flows.

Preferably, the cooling pipe is bonded to the circuit board using an adhesive and is integrally molded in the resin portion.

Preferably, the cooling pipe is arranged such that engine cooling water flows as the coolant through the cooling pipe.

To achieve the above object, the present invention also provides an engine control circuit device comprising a circuit board on which a plurality of packaged electronic parts are mounted, and a connector mounted on the circuit board for connection to an external circuit, wherein the engine control circuit device further comprises a resin portion formed of a thermo-setting resin and covering the connector except for a connecting portion thereof and the circuit board; and a cooling passage formed in the resin portion and allowing a coolant to flow through the cooling passage, thereby cooling the resin portion.

(6) To achieve the above object, the present invention further provides an engine control circuit device comprising a circuit board on which a plurality of packaged electronic parts are mounted, and a connector mounted on the circuit board for connection to an external circuit, wherein the engine control circuit device further comprises a resin portion formed of a thermo-setting resin and covering the connector except for a connecting portion thereof and the circuit board; and a metal-made heat sink integrally molded in the resin portion.

Preferably, the heat sink is bonded to the circuit board using an adhesive and is integrally molded in the resin portion.

Preferably, the heat sink has mount holes formed therein for fixing in place.

Preferably, the circuit board has one or more thermal vias formed therein for radiating heat from one to the other side of the circuit board.

Preferably, the circuit board is formed of a flexible substrate.

Preferably, the resin portion is molded such that an illuminating electronic part is surrounded by a transparent thermo-setting resin.

According to the present invention, it is possible to increase heat resistance of the engine control circuit device, and to install the device in a place exposed to severe thermal environments.

### BRIEF DESCRIPTION OF THE DRAWINGS

Fig. 1 is a vertical sectional view showing an overall structure of an engine control circuit device according to a first embodiment of the present invention;
Fig. 2 is a vertical sectional view for explaining a method of manufacturing the engine control circuit device according to the first embodiment of the present invention;
Fig. 3 is a vertical sectional view showing an overall structure of one modification of the engine control circuit device according to the first embodiment of the present invention;
Fig. 4 is a horizontal sectional view taken along the line IV-IV in Fig. 3;
Fig. 5 is a vertical sectional view showing an overall structure of an engine control circuit device according to a second embodiment of the present invention;
Fig. 6 is a vertical sectional view for explaining a method of manufacturing the engine control circuit device according to the second embodiment of the present invention;
Fig. 7 is a partial enlarged vertical sectional view showing a detailed structure of a connector in one modification of the engine control circuit device according to the second embodiment of the present invention;
Fig. 8 is a partial enlarged vertical sectional view showing a detailed structure of a connector in another modification of the engine control circuit device according to the second embodiment of the present invention;
Fig. 9 is a vertical sectional view showing an overall structure of an engine control circuit device according to a third embodiment of the present invention;
Fig. 10 is a partial enlarged vertical sectional view showing a detailed structure of one modification of the engine control circuit device according to the present invention;
Fig. 11 is a partial enlarged vertical sectional view showing a detailed structure of another modification of the engine control circuit device according to the present invention;
Fig. 12 is a partial enlarged vertical sectional view showing a detailed structure of still another modification of the engine control circuit device according to the present invention;
Fig. 13 is a partial enlarged vertical sectional view showing a detailed structure of still another modification of the engine control circuit device according to the present invention;
Fig. 14 is a partial enlarged vertical sectional view showing a detailed structure of still another modification of the engine control circuit device according to the present invention;
Fig. 15 is a partial enlarged vertical sectional view showing a detailed structure of still another modification of the engine control circuit device according to the present invention;
Fig. 16 is a partial enlarged vertical sectional view showing a detailed structure of still another modification of the engine control circuit device according to the present invention;
Fig. 17 is a partial enlarged vertical sectional view showing a detailed structure of still another modification of the engine control circuit device according to the present invention;
Fig. 18 is a vertical sectional view showing an overall structure of an engine control circuit device according to a fourth embodiment of the present invention;
Fig. 19 is a vertical sectional view for explaining a method of manufacturing the engine control circuit device according to the fourth embodiment of the present invention;
Fig. 20 is a vertical sectional view showing an overall structure of one modification of the engine control circuit device according to the fourth embodiment of the present invention;
Fig. 21 is a vertical sectional view showing an overall structure of an engine control circuit device according to a fifth embodiment of the present invention;
Fig. 22 is a vertical sectional view showing an overall structure of an engine control circuit device according to a sixth embodiment of the present invention; and
Fig. 23 is a vertical sectional view showing an overall structure of one modification of the engine control circuit device according to the sixth embodiment of the present invention.

### DESCRIPTION OF THE PREFERRED EMBODIMENTS

Embodiments of the present invention will be described below with reference to the drawings.

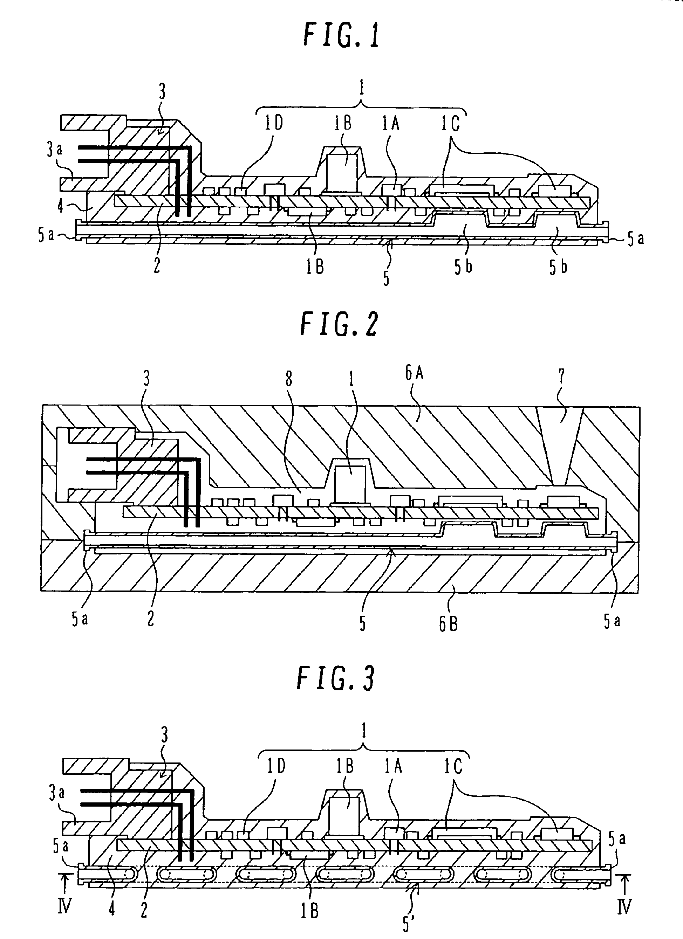

A first embodiment of the present invention will be described with reference to Figs. 1 and 2.

Fig. 1 is a vertical sectional view showing an overall structure of an engine control circuit device according to the first embodiment of the present invention.

In Fig. 1, the engine control circuit device comprises a circuit board 2 including a plurality of packaged electronic parts 1 mounted on, e.g., both surfaces thereof, a connector 3 for connection to an external circuit (not shown), a resin portion 4 formed of a thermo-setting resin and covering the connector 3 except for a connecting portion 3a thereof and the entirety of the circuit board 2, and a cooling pipe 5 (cooling means) disposed below the circuit board 2 (on the lower side as viewed in Fig. 1) and integrally molded in the resin portion 4. A coolant flows through the cooling pipe 5 to cool the resin portion 4.

The electronic parts 1 include, for example, board-inserted electronic parts 1A (such as a resistor, a capacitor, a coil, a crystal, a diode, an IC, a FET, and a transistor), surface-mounted large-sized electronic parts 1B (such as a microcomputer, a capacitor, a coil, a crystal, a diode, a transistor, and an IC), highly heating electronic parts 1C (such as a power FET, a power transistor, a power diode, a power Zener diode, a power IC, a power IPD (Intelligent Power Device), and a microcomputer each provided with a metal-made heat sink or fins), and chip-type electronic parts 1D (such as a capacitor, a resistor, a diode, a coil, an IC, a transistor, a FET, and a crystal).

The circuit board 2 is a resin-type printed wiring board made of, e.g., an epoxy resin or a polyimide resin mixed with glass fibers, and has a linear thermal expansion coefficient of about 14 ppm/°C. Also, the glass-transition temperature of the circuit board 2 is set to a high value so that the board has increased heat resistance.

The resin portion 4 is formed of a thermo-setting resin, such as an epoxy resin or a phenol resin, and has a linear thermal expansion coefficient of 8 - 24 ppm/°C, the coefficient of elasticity of 8 - 39 GPa, and the glass-transition temperature of 80 - 200°C.

The cooling pipe 5 has open ends 5a formed at opposite pipe ends (on the left and right sides as viewed in Fig. 1) for connection to external piping (not shown). For example, an engine coolant flows through the cooling pipe 5 in a state where the cooling pipe 5 is connected to the external piping. To efficiently cool, e.g., the highly heating electronic parts 1C mounted on the upper surface of the circuit board 2 (i.e., the surface of the circuit board 2 opposed to the cooling pipe 5), the cooling pipe 5 has section-enlarged areas 5b where a channel section is enlarged so as to make a pipe wall position closer to the circuit board 2 (i.e., offset upward as viewed in Fig. 1). More specifically, the cooling pipe 5 is arranged close to the circuit board 2 to such an extent that the distance between the pipe wall and the electronic parts 1 mounted to the lower surface of the circuit board 2 is, e.g., about 1 mm.

A method of manufacturing the engine control circuit device according to the first embodiment will be described below. Fig. 2 is a vertical sectional view for explaining the method of manufacturing the engine control circuit device according to the first embodiment.

In Fig. 2, a die used for molding the resin portion 4 is of, e.g., a two-split structure comprising an upper die 6A and a lower die 6B. When the upper die 6A and the lower die 6B are mated with each other, the cooling pipe 5 is supported in place in a state where the open ends 5a at the opposite ends of the cooling pipe 5 are closed. Though not shown in detail, the circuit board 2 including the plurality of electronic parts 1 and the connector 3 mounted thereon is supported by the upper die 6A. Then, the thermo-setting resin is injected under pressure into a cavity 8 defined inside both the dies 6A, 6B through an injection port 7 of the upper die 6A, thereby forming the resin portion 4 in which the circuit board 2 and the cooling pipe 5 are integrally molded using the thermo-setting resin.

With this first embodiment thus constructed, since the circuit board 2 including the plurality of electronic parts 1 and the connector 3 mounted thereon is covered with the resin portion 4 made of the thermo-setting resin having good heat conductance, heat radiation from the electronic parts 1 can be increased. Further, since the resin portion 4 is cooled through the cooling pipe 5 which is integrally molded in the resin portion 4, the entirety of the engine control circuit device including the highly heating electronic parts 1C, etc. can be efficiently cooled. Stated another way, the electronic parts 1 having an operational temperature range of, e.g., 125°C or below can be efficiently cooled, and the engine control circuit device is further adaptable even for the on-engine mounting that causes the device to be exposed to severe thermal environments at 130°C or higher. In addition, the linear thermal expansion coefficient of the thermo-setting resin is generally lower than that of the thermoplastic resin, and can be set closer to the linear thermal expansion coefficient of the circuit board 2 (for example, the linear thermal expansion coefficient of the resin-made printed wiring board is about 14 ppm/°C). This is effective in suppressing damages of the electronic parts 1, which is attributable to thermal expansion. It is therefore possible to increase heat resistance of the engine control circuit device and to install the device in a place exposed to severe thermal environments.

Also, with this first embodiment, since the resin-made printed wiring board is employed as the circuit board 2, the engine control circuit device can be manufactured at a lower cost and higher productivity than the case of employing, e.g., a ceramic substrate having high heat resistance, while ensuring high durability based on high flexibility. Another advantage is that the known electronic part mounting techniques are available in production steps. Incidentally, if a ceramic substrate is used to form the circuit board 2, a difficulty rises in enlarging the device size because of a limitation in substrate size and an increase of the cost.

Further, with this first embodiment, since the plurality of electronic parts 1 (and the cooling pipe 5) are fixedly molded in the resin portion 4, influences of engine vibrations can be reduced and durability can be increased. Additionally, advantageous characteristics of the resin portion 4, such as insulation and water tightness, can be given to the engine control circuit device. In other words, because of the circuit board 2 being covered with the resin portion 4, even if, for example, the cooling pipe 5 is damaged, it is possible to prevent malfunctions, damages and other troubles of the electronic circuits, which are otherwise caused by leakage of the coolant. Moreover, since the resin portion 4 is made of the thermo-setting resin, the resin setting time can be cut and productivity can be increased as compared with the case of using a thermoplastic resin to form the resin portion 4.

In this first embodiment, for the purpose of increasing the cooling efficiency, various contrivances can be easily practiced, as given in detail below, to increase the amount of heat transferred between the electronic parts 1 and the cooling pipe 5.

### (1) Coefficient of Thermal Conductivity of Resin Portion

The coefficient of thermal conductivity of the thermo-setting resin is preferably in the range of 0.2 - 3 W/m·K to avoid such a possibility that the coefficient of thermal conductivity of the resin portion 4 causes a bottleneck in heat transfer and restricts the transfer of heat from the highly heating electronic parts 1C, etc. to the cooling pipe 5. Also, by arranging the cooling pipe 5 so as to position closer to the highly heating electronic parts 1C, etc., the cooling efficiency can be increased. Thus, since the thermo-setting resin and the cooling pipe are adjustable in practical layout, an optimum cooling structure can be provided without undergoing any restrictions in mount positions of the highly heating electronic parts 1C in the stage of board design.

### (2) Cooling Pipe

Preferable materials of the cooling pipe 5 are plastics, rubbers, and metals. Among those materials, metals having good heat conductance, such as copper, iron, aluminum and alloys thereof, are especially preferable from the viewpoint of increasing the cooling efficiency. Also, by forming the cooling pipe 5 such that its channel section is partly modified to have an enlarged heat-radiating area, the cooling efficiency can be increased without changing the overall size of the cooling pipe 5.

### (3) Coolant

By using the coolant flowing through the cooling pipe 5 in common with any of coolants (such as air, engine cooling water, and engine oil) used in ordinary cooling units provided in a vehicle, the cost required for the overall system can be cut. Generally, the cooling effect is obtained at the highest level with forced water-cooling, and then decreases in the order of forced air-cooling and natural air-cooling. Accordingly, when air is used as the coolant, a cooling fan is preferably installed to perform forced cooling. If natural convection of air must be utilized for some reason, relatively high cooling efficiency can be obtained by arranging the cooling pipe 5, for example, such that air flows through the cooling pipe 5 in the vertical direction to allow easier air convection. When water is used as the coolant, a temperature range of the cooling water is preferably -40°C to 110° C. When a corrosive coolant, e.g., saline water, is used as the coolant, an inner wall of the cooling pipe 5 is preferably coated with plating to increase corrosion resistance. Further, in the case of using the cooling water in common with the engine cooling unit, the engine cooling water before being used to cool an engine is preferably introduced to the cooling pipe 5 because the temperature of the cooling water after cooling the engine rises to about 130°C. To prevent the cooling water at high temperature from being introduced to the cooling pipe 5, it is preferable to mount a temperature detecting means, e.g., a chip-type thermistor, on the circuit board 2, to detect the inlet temperature of the cooling pipe 5, and to control detection of a high-temperature abnormality of the cooling water and a system shutdown under control of a microcomputer.

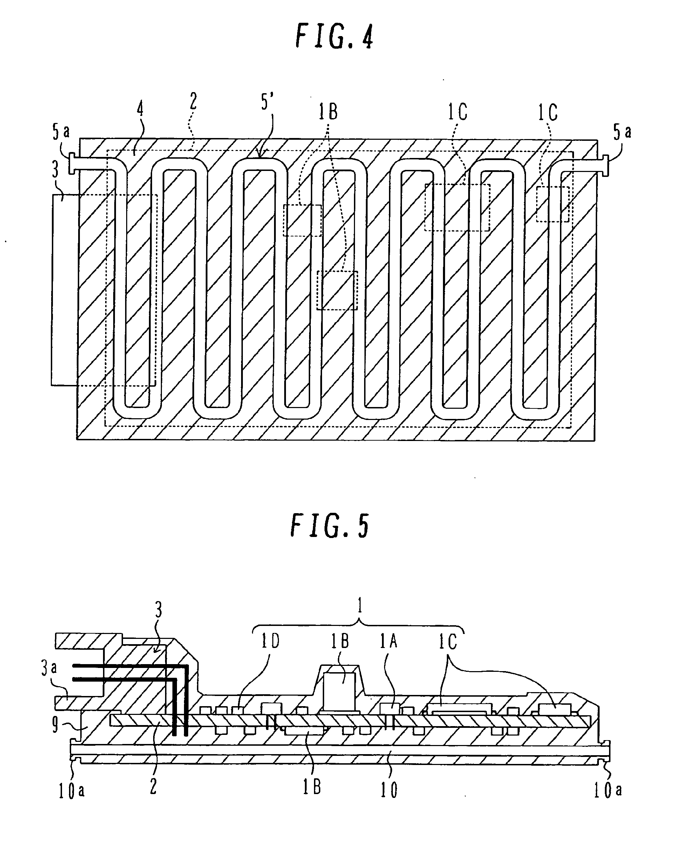

Although layout of the cooling pipe 5 in a horizontal plane is not described in the foregoing first embodiment, the cooling pipe 5 may be arranged in the horizontal plane, by way of example, as shown in Figs. 3 and 4. Fig. 3 is a vertical sectional view showing an overall structure of one modification of the engine control circuit device according to the first embodiment, and Fig. 4 is a horizontal sectional view taken along the line IV-IV in Fig. 3 (note that Fig. 4 shows only a part of the electronic parts 1, i.e., the surface-mounted large-sized electronic parts 1B and the highly heating electronic parts 1C). To more efficiently cool the electronic parts 1 mounted on the circuit board 2, a cooling pipe 5' in this modification is arranged in a zigzag pattern over an entire area of the circuit board 2 with a predetermined spacing left between adjacent parallel pipe portions. This modification can also provide the same advantages as those obtained with the first embodiment. Additionally, the open ends 5a (inlet and outlet) of the cooling pipe 5 may be located at positions close to each other. This layout enables the cooling pipe 5 to be more easily connected to the external piping.

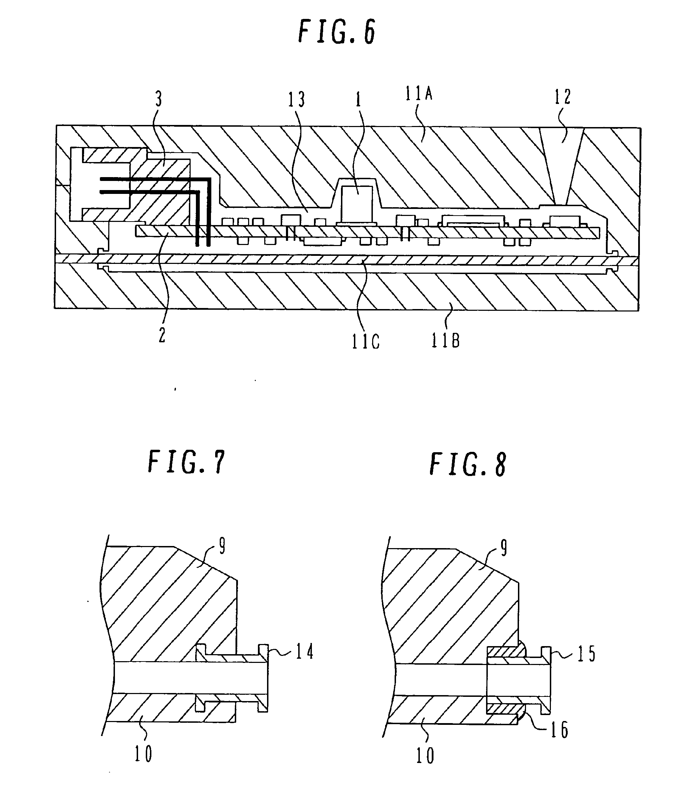

A second embodiment of the present invention will be described below with reference to Figs. 5 and 6. In this second embodiment, a cooling passage is formed in the resin portion.

Fig. 5 is a vertical sectional view showing an overall structure of an engine control circuit device according to the second embodiment, and Fig. 6 is a vertical sectional view for explaining a method of manufacturing the engine control circuit device according to the second embodiment. Identical components in Figs. 5 and 6 to those in the first embodiment are denoted by the same symbols and a description of those components is omitted here.

The engine control circuit device according to the second embodiment includes a resin portion 9 formed of a thermo-setting resin and covering a connector 3 except for a connecting portion 3a thereof and the entirety of a circuit board 2, and a cooling passage 10 formed in the resin portion 9 to extend, for example, below the circuit board 2 (on the lower side as viewed in Fig. 5). A coolant flows through the cooling passage 10 to cool the resin portion 9. The cooling passage 10 has open ends 10a formed of a thermo-setting resin and positioned at opposite passage ends (on the left and right sides as viewed in Fig. 5) for connection to external piping.

A die used for molding the resin portion 9 is made up of, by way of example, an upper die 11A, a lower die 11B, and a rod-shaped core 11C made of a material that is easily releasable from the dies. When the upper die 11A and the lower die 11B are mated with each other, the rod-shaped core 11C is supported between both the dies. Though not shown in detail, the circuit board 2 including a plurality of electronic parts 1 and the connector 3 mounted thereon is supported by the upper die 11A. Then, the thermo-setting resin is injected under pressure into a cavity 13 defined inside both the dies 11A, 11B through an injection port 12 of the upper die 11A, thereby molding the resin portion 9 so as to cover the whole of the circuit board 2. By removing the rod-shaped core 11C from the resin portion 9, the cooling passage 10 is formed.

As with the first embodiment, this second embodiment constructed as described above can also realize an engine control circuit device that has higher heat resistance and can be installed in a place exposed to severe thermal environments. As compared with the first embodiment, since the cooling pipe 5 is not required, the number of parts and the assembly work can be lessened, thus resulting in a lower cost.

While the second embodiment has been described, by way of example, in connection with the structure where the open ends 10a at the opposite ends of the cooling passage 10 are formed of a thermo-setting resin, the present invention is not limited to that structure. More specifically, to avoid the open ends 10a from being subjected to stresses in a concentrated way and from being damaged when the open ends 10a are forcibly connected to the external piping in piping connection work, the opposite ends of the cooling passage 10 may be modified so as to include connectors made of, e.g., a metal (or a highly strong resin). Figs. 7 and 8 are each a partial enlarged vertical sectional view showing a detailed structure of the connector in such a modification.

In the modification shown in Fig. 7, the resin portion 9 is molded such that a connector 14 is embedded in the resin portion 9 and coupled to the cooling passage 10. In the modification shown in Fig. 8, after molding the resin portion 9, a connector 15 is attached to the cooling passage 10 by an adhesive 16 (or laser welding, etc.). These modifications can also provide the same advantages as those described above.

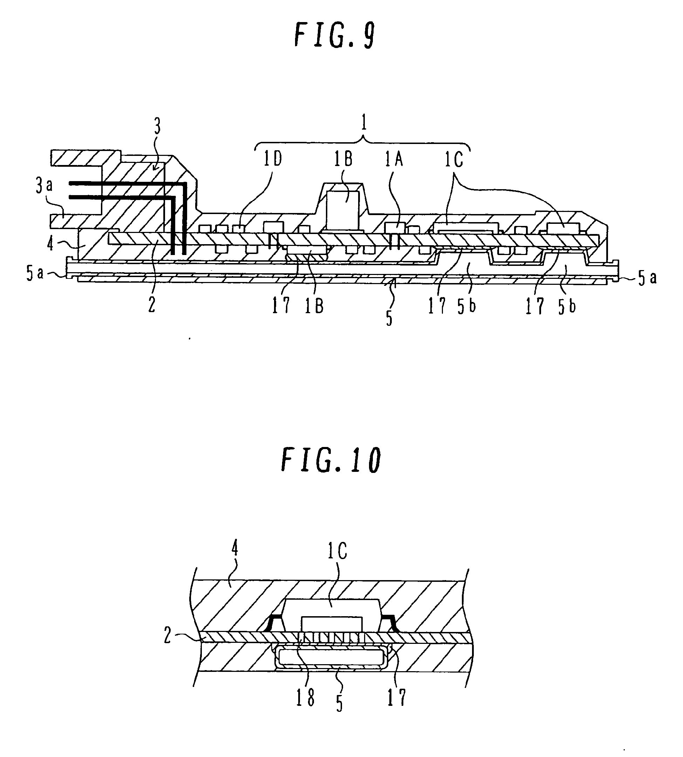

A third embodiment of the present invention will be described below with reference to Fig. 9. In this third embodiment, the cooling pipe 5 in the first embodiment is bonded to the circuit board 2, etc. by an adhesive.

Fig. 9 is a vertical sectional view showing an overall structure of an engine control circuit device according to the third embodiment. Identical components in Fig. 9 to those in the above-mentioned embodiments are denoted by the same symbols and a description of those components is omitted here.

In this third embodiment, the cooling pipe 5 disposed below the circuit board 2 (on the lower side as viewed in Fig. 9) is bonded, using an insulating adhesive 17, to not only the lower surface of the circuit board 2 in areas corresponding to the highly heating electronic parts 1C mounted on the upper surface of the circuit board 2, but also to some of electronic parts 1 mounted on the lower surface of the circuit board 2 (e.g., the surface-mounted large-sized electronic part 1B in Fig. 9). In such a state, the resin portion 4 is molded integrally with the cooling pipe 5. Stated another way, the adhesive 17 serves to tentatively fix the cooling pipe 5 to the circuit board 2 until the resin portion 4 is molded, and also serves to insulate the cooling pipe 5 from the circuit board 2. From the viewpoint of easiness in application, the adhesive 17 is preferably in the form of a liquid or in the other easily applicable form such as a double-coated adhesive tape or sheet. Further, the adhesive 17 having a high coefficient of thermal conductivity is preferably used to avoid such a possibility that a low coefficient of thermal conductivity of the adhesive 17 causes a bottleneck in heat transfer and restricts the transfer of heat from the highly heating electronic parts 1C, etc. to the cooling pipe 5.

As with the first embodiment, this third embodiment constructed as described above can also realize an engine control circuit device that has higher heat resistance and can be installed in a place exposed to severe thermal environments.

Although not specifically described in the forgoing first to third embodiments, the circuit board 2 may be provided with a thermal via (via hole) formed therein to release heat from one to the other surface of the circuit board 2. Figs. 10 to 12 are each a partial enlarged vertical sectional view showing a detailed structure of the engine control circuit device according to such a modification.

In the modification shown in Fig. 10, the cooling pipe 5 is bonded to the lower surface of the circuit board 2 using the adhesive 17 and is integrally molded in the resin portion 4. The highly heating electronic part 1C is mounted on the upper surface of the circuit board 2, and a plurality of thermal vias 18 are formed through the circuit board 2 in an area close to the highly heating electronic part 1C. With such an arrangement, heat generated from the highly heating electronic part 1C is released toward the lower side of the circuit board 2 through the thermal vias 18 and is cooled by the cooling pipe 5 through the adhesive 17.

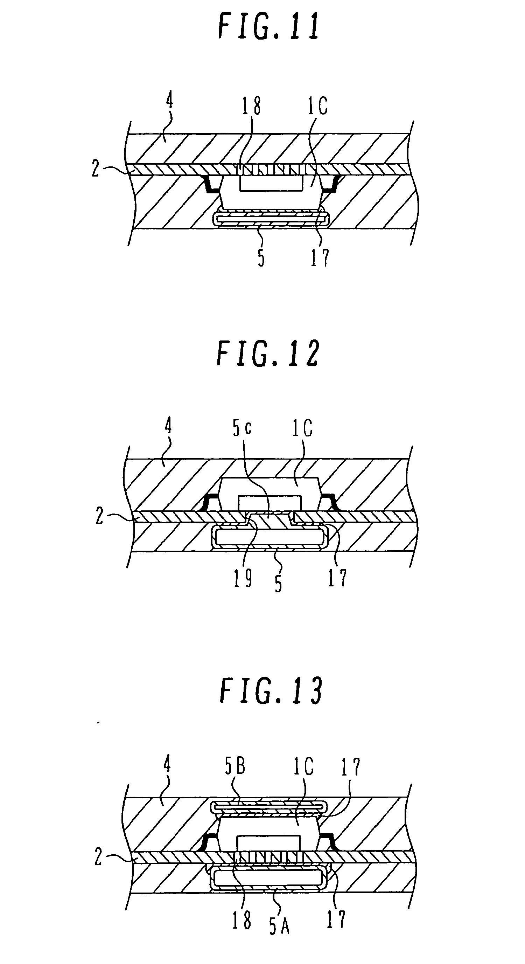

In the modification shown in Fig. 11, the cooling pipe 5 is bonded, using the adhesive 17, to the highly heating electronic part 1C mounted on the lower surface of the circuit board 2, and is integrally molded in the resin portion 4. A plurality of thermal vias 18 are formed through the circuit board 2 in an area close to the highly heating electronic part 1C. With such an arrangement, heat generated from the highly heating electronic part 1C is cooled by the cooling pipe 5 through the adhesive 17 and is released toward the upper side of the circuit board 2 through the thermal vias 18.

In the modification shown in Fig. 12, the highly heating electronic part 1C is mounted on the upper surface of the circuit board 2, and a thermal via 19 is formed through the circuit board 2 in an area close to the highly heating electronic part 1C. The cooling pipe 5 is disposed below the circuit board 2 and has a projection 5c that is projected toward the circuit board side (upward as viewed in Fig. 12) and inserted into the thermal via 19 of the circuit board 2. Further, the cooling pipe 5 is bonded to the highly heating electronic part 1C and the circuit board 2 using the adhesive 17. With such an arrangement, heat generated from the highly heating electronic part 1C is released toward the lower side of the circuit board 2 through the adhesive 17 and is cooled by the cooling pipe 5.

With the modifications shown in Figs. 10 to 12, heat radiation efficiency can be further increased by forming the thermal vias 18 or via 19 in the circuit board 2.

Although the foregoing embodiments and modifications have been described, by way of example, in connection with the structure where the cooling pipe 5 (or the cooling passage 10) is disposed only on one side, i.e., on the lower side of the circuit board 2, it may be disposed only on the upper side of the circuit board 2. As an alternative, it may be disposed on each of the upper and lower sides of the circuit board 2. Such a modification will be described with reference to Figs. 13 to 15.

In the modification shown in Fig. 13, the highly heating electronic part 1C is mounted on the upper surface of the circuit board 2, and a plurality of thermal vias 18 are formed through the circuit board 2 in an area close to the highly heating electronic part 1C. A cooling pipe 5A disposed on the lower side of the circuit board 2 is bonded to the circuit board 2 using the adhesive 17 and is integrally molded in the resin portion 4. On the other hand, a cooling pipe 5B disposed on the upper side of the circuit board 2 is bonded to the highly heating electronic part 1C using the adhesive 17 and is also integrally molded in the resin portion 4. With such an arrangement, heat generated from the highly heating electronic part 1C is released toward the lower side of the circuit board 2 through the thermal vias 18 and is cooled by the cooling pipe 5A through the adhesive 17, while the heat is further cooled by the cooling pipe 5B through the adhesive 17.

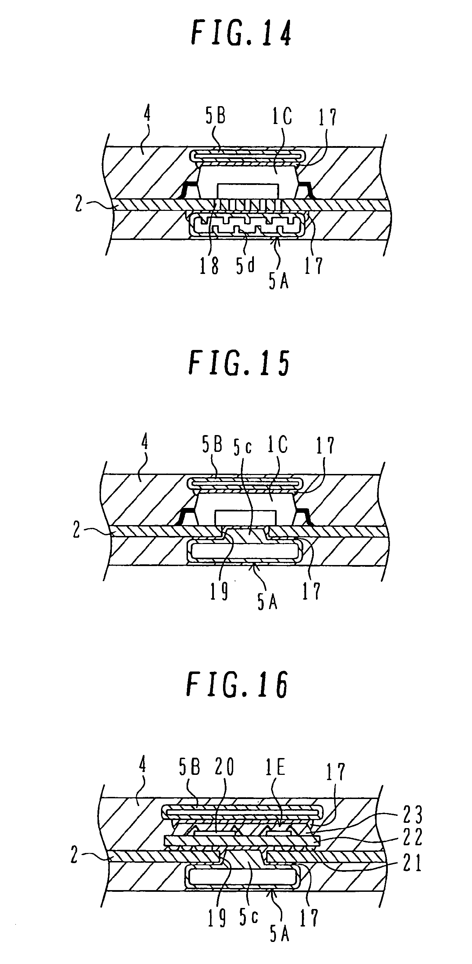

In the modification shown in Fig. 14, in addition to the construction of the modification shown in Fig. 13, the cooling pipe 5A is formed to have projections 5d in channel section thereof. As a result, the surface area of the cooling pipe 5A is increased and the cooling efficiency is enhanced.

In the modification shown in Fig. 15, the highly heating electronic part 1C is mounted on the upper surface of the circuit board 2, and a thermal via 19 is formed through the circuit board 2 in an area close to the highly heating electronic part 1C. A cooling pipe 5A disposed on the lower side of the circuit board 2 has a projection 5c that is projected toward the circuit board 2 (upward as viewed in Fig. 15) and inserted into the thermal via 19 of the circuit board 2. Further, the cooling pipe 5A is bonded to the highly heating electronic part 1C and the circuit board 2 using the adhesive 17, and is integrally molded in the resin portion 4. On the other hand, a cooling pipe 5B disposed on the upper side of the circuit board 2 is bonded to the highly heating electronic part 1C using the adhesive 17, and is also integrally molded in the resin portion 4. With such an arrangement, the highly heating electronic part 1C is cooled by both the cooling pipes 5A, 5B through the adhesives 17.

In the modification shown in Fig. 16, a semiconductor module 1E (e.g., a BGA (Ball Grid Array) package), a flip-chip, or a multi-chip-module (MCM)) is mounted on the upper surface of the circuit board 2. The semiconductor module 1E comprises a bare chip 20, a ball grid array (BGA) 21 serving as a portion for connection to an external circuit, a substrate 22 for connecting the bare chip 20 and the BGA 21, and a resin 23 molded to package all of those components therein. A thermal via 19 is formed through the circuit board 2 in an area close to the semiconductor module 1E. A cooling pipe 5A disposed on the lower side of the circuit board 2 has a projection 5c that is projected toward the circuit board 2 (upward as viewed in Fig. 16) and inserted into the thermal via 19 of the circuit board 2. Further, the cooling pipe 5A is bonded to the semiconductor module 1E and the circuit board 2 using the adhesive 17, and is integrally molded in the resin portion 4. A cooling pipe 5B disposed on the upper side of the circuit board 2 is bonded to the semiconductor module 1E using the adhesive 17, and is integrally molded in the resin portion 4. With such an arrangement, the semiconductor module 1E is cooled by both the cooling pipes 5A, 5B through the adhesives 17.

With the modifications shown in Figs. 13 to 16, the electronic parts are cooled by both the cooling pipes 5A, 5B disposed on the upper and lower sides of the circuit board 2, thus resulting higher cooling efficiency.

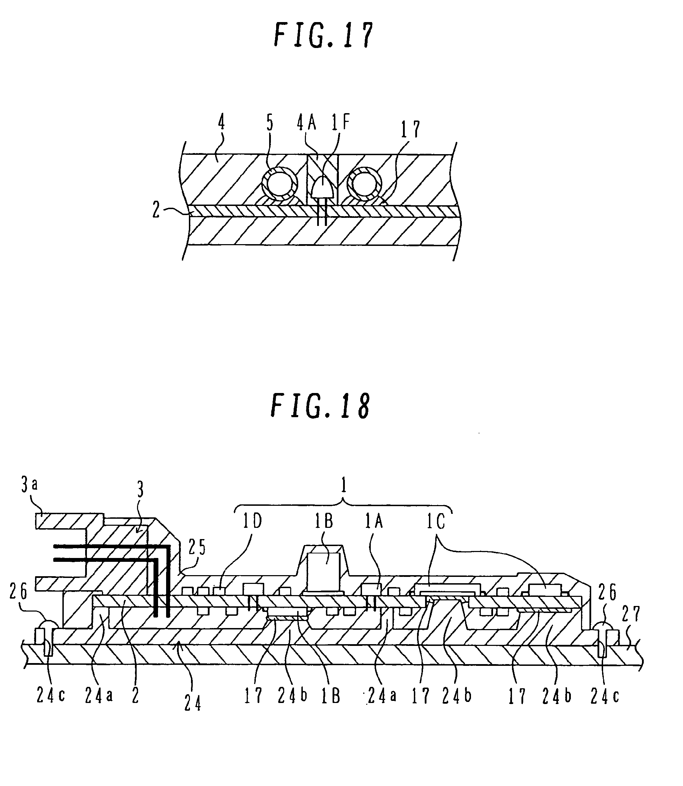

Although not specifically described in the forgoing embodiments and modifications, a resin portion 4A may be molded such that, as shown in Fig. 17 by way of example, a transparent thermo-setting resin is used as a part of the resin portion 4A in an area surrounding an illuminating electronic part 1F (e.g., a LED, namely a means for informing a user of an abnormality alarm, confirmation of normal conditions, or any other check item).

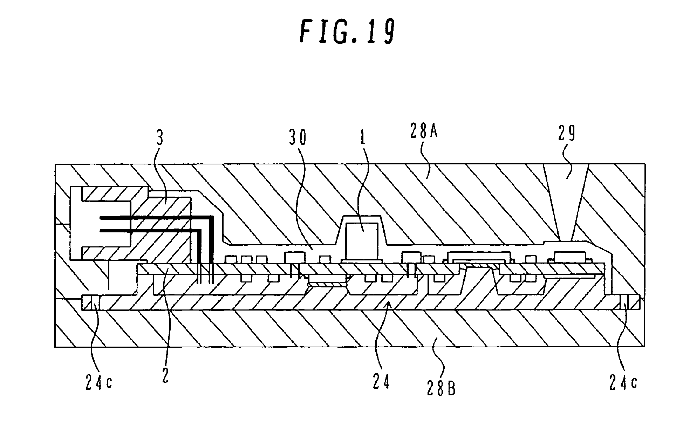

A fourth embodiment of the present invention will be described below with reference to Figs. 18 and 19. In this fourth embodiment, a metal-made heat sink is integrally molded in the resin portion.

Fig. 18 is a vertical sectional view showing an overall structure of an engine control circuit device according to the fourth embodiment, and Fig. 19 is a vertical sectional view for explaining a method of manufacturing the engine control circuit device according to the fourth embodiment. Identical components in Figs. 18 and 19 to those in the foregoing embodiments are denoted by the same symbols and a description of those components is omitted here.

The engine control circuit device according to the fourth embodiment includes a metal-made heat sink 24 (cooling means) disposed below a circuit board 2 (on the lower side as viewed in Fig. 18), and a resin portion 25 formed of a thermo-setting resin and covering the heat sink 24 on the side facing the circuit board 2 (on the upper side as viewed in Fig. 18), a connector 3 except for a connecting portion 3a thereof, and the entirety of the circuit board 2.

The heat sink 24 has connecting portions 24a connected to the circuit board 2 with intent to enhance noise immunity of the circuit board 2 and to increase heat conductance, and also has projections 24b projected so as to approach the circuit board 2 with intent to increase the effect of cooling the electronic parts 1. The projections 24b are bonded to the electronic parts 1, the circuit board 2, etc. by insulating adhesives 17. Further, the heat sink 24 has a plurality of mount holes 24c formed in areas where the resin portion 25 is not molded, and bolts 26 are inserted through the mount holes 24c for mounting the heat sink 24 to a fixed wall 27 (such as an engine room sidewall, an engine block sidewall, an engine head, a radiator, or an intake manifold). As materials of the heat sink 24, metals having good heat conductance, such as copper, iron, aluminum and alloys thereof, are preferable from the viewpoint of increasing the cooling effect. Also, the heat sink 24 is arranged close to the circuit board 2 to such an extent that the distance between the heat sink and the electronic parts 1 mounted to the lower surface of the circuit board 2 is, e.g., about 1 mm.

A die used for molding the resin portion 25 is of, e.g., a two-split structure comprising an upper die 28A and a lower die 28B. The heat sink 24 is supported by the lower die 28B in a state where the mount holes 24c of the heat sink 24 are closed. The circuit board 2 including the plurality of electronic parts 1 and the connector 3 mounted thereon is supported by the upper die 28A. Then, the thermo-setting resin is injected under pressure into a cavity 30 defined inside both the dies 28A, 28B through an injection port 29 of the upper die 28A, thereby forming the resin portion 25 in which the circuit board 2 and the heat sink 24 are integrally molded using the thermo-setting resin.

As with the foregoing embodiments, this fourth embodiment constructed as described above can also realize an engine control circuit device that has higher heat resistance and can be installed in a place exposed to severe thermal environments. Further, since the heat sink 24 serves also as a fixture for fixing the device, the number of parts and the assembly work can be lessened, thus resulting in a lower cost.

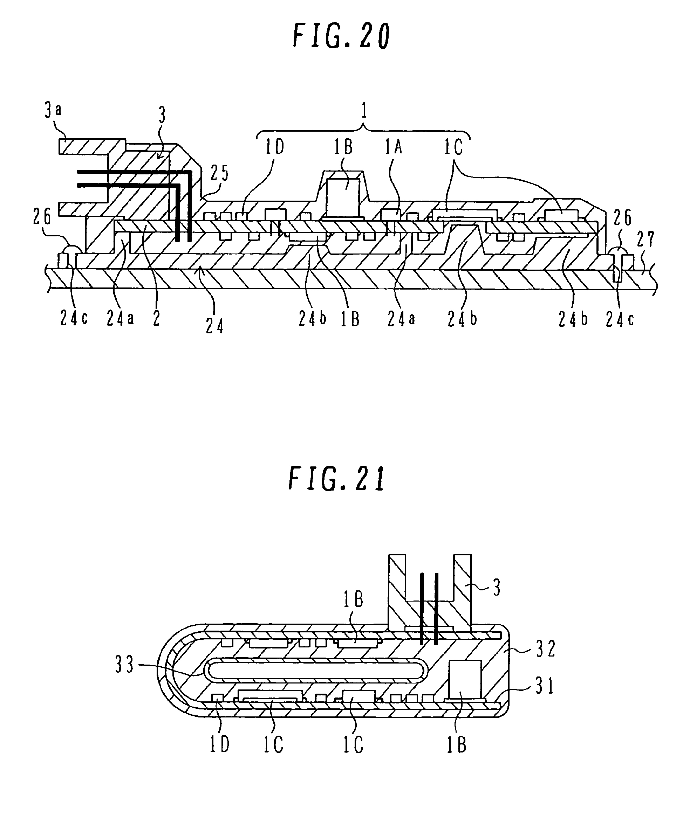

While the fourth embodiment has been described, by way of example, in connection with the structure where the heat sink 24 is bonded to the circuit board 2, etc. using the adhesives 17, the present invention is not limited to that structure. It is needless to say that, as shown in Fig. 20, a similar structure can also be realized without using the adhesive 17.

A fifth embodiment of the present invention will be described below with reference to Fig. 21. In this fifth embodiment, the circuit board is formed of a flexible substrate and the cooling pipe is integrally molded in the resin portion.

Fig. 21 is a vertical sectional view showing an overall structure of an engine control circuit device according to the fifth embodiment. Identical components in Fig. 21 to those in the above-mentioned embodiments are denoted by the same symbols and a description of those components is omitted here.

In this fifth embodiment, a circuit board 31 is formed of a flexible substrate made of, e.g., a polyimide resin or a liquid crystal polymer (or a composite substrate comprising a rigid portion and a flexible portion, in which only a bent portion is formed of a flexible substrate). The circuit board 31 is bent at a midpoint into the U-form so that a projection area of the circuit board is halved. The electronic parts 1 (such as the surface-mounted large-sized electronic parts 1B, the highly heating electronic parts 1C, and the chip-type electronic part 1D) are mounted on an inner surface of the circuit board 31 in areas where the board is not bent, and the connector 3 is mounted on an outer surface of the circuit board 31 in an area where the board is not bent. The engine control circuit device according to this fifth embodiment includes a resin portion 32 formed of a thermo-setting resin and covering the entirety of the circuit board 31, and a cooling pipe 33 disposed inside the circuit board 31 to be out of interference with the electronic parts 1 and integrally molded in the resin portion 32. A coolant flows through the cooling pipe 33 to cool the resin portion 32. Though not shown in detail, the cooling pipe 33 is connected to external piping and, for example, engine cooling water flows through the cooling pipe 33 in a direction perpendicular to the drawing sheet of Fig. 21.

As with the foregoing embodiments, this fifth embodiment constructed as described above can also realize an engine control circuit device that has higher heat resistance and can be installed in a place exposed to severe thermal environments. Further, since the circuit board 31 is formed of a flexible substrate and bent into the U-form, the device size can be reduced.

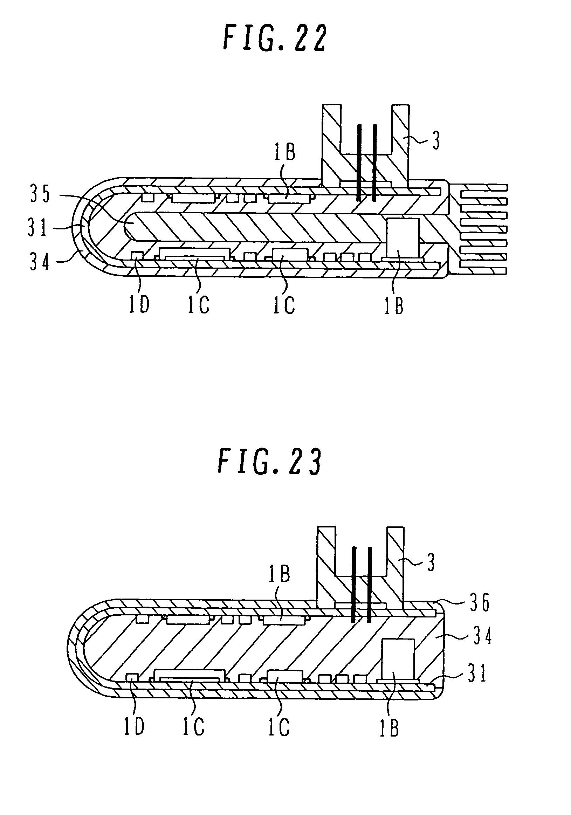

A sixth embodiment of the present invention will be described below with reference to Fig. 22. In this sixth embodiment, the circuit board is formed of a flexible substrate and a metal-made heat sink is integrally molded in the resin portion.

Fig. 22 is a vertical sectional view showing an overall structure of an engine control circuit device according to the sixth embodiment. Identical components in Fig. 22 to those in the above-mentioned embodiments are denoted by the same symbols and a description of those components is omitted here.

The engine control circuit device according to this sixth embodiment includes a resin portion 34 formed of a thermo-setting resin and covering the entirety of the circuit board 31, and a metal-made heat sink 35 disposed inside the circuit board 31 to be out of interference with the electronic parts 1 and integrally molded in the resin portion 34. A part of the heat sink 35 (right end part as viewed in Fig. 22), which is exposed to the outside from the resin portion 34, is of a fin structure for increasing a heat radiating area.

As with the foregoing embodiments, this sixth embodiment constructed as described above can also realize an engine control circuit device that has higher heat resistance and can be installed in a place exposed to severe thermal environments. Further, since the circuit board 31 is formed of a flexible substrate and bent into the U-form, the device size can be reduced.

While the sixth embodiment has been described, by way of example, in connection with the structure where the heat sink 35 is disposed inside the circuit board 31, the present invention is not limited to that structure, and the heat sink 35 may be disposed outside the circuit board 31. Fig. 23 is a vertical sectional view showing an overall structure of an engine control circuit device according to such a modification.

In the modification shown in Fig. 23, a metal-made heat sink 36 is integrally molded in the resin portion 34 such that the heat sink 36 is disposed to be out of interference with the connector 3 in contact with an outer surface of the circuit board 31. As an alternative, the heat sink 36 may be bonded to the circuit board 31 by an adhesive having a high coefficient of elasticity. Either modification can also provide the same advantages as those mentioned above.

Details of the structures of the above described embodiments 1-6 may be combined to form further embodiments fitting to the particular demands of a respective application. As far as those modifications are readily apparent for an expert skilled in the art, they shall be included implicitly by the above description of embodiments 1-6.

## Claims

1. An engine control circuit device comprising a circuit board (2) on which a plurality of packaged electronic parts are mounted, and a connector (3) mounted on said circuit board for connection to an external circuit,
wherein said engine control circuit device further comprises a resin portion (4) formed of a thermo-setting resin and covering said connector (3) except for a connecting portion thereof and said circuit board (2); and
cooling means integrally molded in said resin portion (4) and cooling said resin portion (4).

2. The engine control circuit device according to Claim 1, wherein said cooling means is a cooling pipe (5) through which a coolant flows.

3. The engine control circuit device according to Claim 2, wherein said cooling pipe (5) is bonded to said circuit board (2) using an adhesive (17) and is integrally molded in said resin portion (4).

4. The engine control circuit device according to Claim 2 or 3, wherein said cooling pipe (5) is arranged such that engine cooling water flows as said coolant through said cooling pipe (5).

5. An engine control circuit device comprising a circuit board (2) on which a plurality of packaged electronic parts (1) are mounted, and a connector (3) mounted on said circuit board for connection to an external circuit,
wherein said engine control circuit device further comprises a resin portion (4) formed of a thermo-setting resin and covering said connector (3) except for a connecting portion thereof and said circuit board (2); and
a cooling passage formed in said resin portion (4) and allowing a coolant to flow through said cooling passage, thereby cooling said resin portion.

6. An engine control circuit device comprising a circuit board (2) on which a plurality of packaged electronic parts (1) are mounted, and a connector (3) mounted on said circuit board for connection to an external circuit,
wherein said engine control circuit device further comprises a resin portion (4) formed of a thermo-setting resin and covering said connector (3) except for a connecting portion thereof and said circuit board (2); and
a metal-made heat sink integrally molded in said resin portion.

7. The engine control circuit device according to Claim 6, wherein said heat sink (24) is bonded to said circuit board (2) using an adhesive and is integrally molded in said resin portion (4).

8. The engine control circuit device according to Claim 6 or 7, wherein said heat sink (24) has mount holes (24c) formed therein for fixing in place.

9. The engine control circuit device according to any of the preceding Claims, wherein said circuit board (2) has one or more thermal vias formed therein for radiating heat from one to the other side of said circuit board.

10. The engine control circuit device according to any of the preceding Claims, wherein said circuit board (2) is formed of a flexible substrate.

11. The engine control circuit device according to any of the preceding Claims, wherein said resin portion (4) is molded such that an illuminating electronic part is surrounded by a transparent thermo-setting resin.

## Patentansprüche

1. Motorsteuerungsschaltungsvorrichtung, die aufweist eine Leiterplatte (2), auf der eine Vielzahl von elektronischen Bauteilen angebracht sind, und einen auf der Leiterplatte angebrachten Verbinder (3) zur Verbindung mit einer externen Schaltung,
wobei die Motorsteuerungsschaltungsvorrichtung weiter aufweist einen Harzteil (4), der aus einem aushärtenden Harz gebildet wird und den Verbinder (3) abdeckt bis auf einen Verbindungsteil davon und die Leiterplatte (2); und
Kühlmittel, die integral mit dem Harzteil (4) ausgebildet sind und den Harzteil (4) kühlen.

2. Motorsteuerungsschaltungsvorrichtung gemäß Anspruch 1, wobei das Kühlmittel ein Kühlrohr (5) ist, durch das ein Kühlmittel fließt.

3. Motorsteuerungsschaltungsvorrichtung gemäß Anspruch 2, wobei das Kühlrohr (5) mit der Leiterplatte (2) unter Verwendung eines Klebemittels (17) verbunden ist und integral mit dem Harzteil (4) ausgebildet ist.

4. Motorsteuerungsschaltungsvorrichtung gemäß Anspruch 2 oder 3, wobei das Kühlrohr (5) derart ausgebildet ist, dass Motorkühlwasser als Kühlmittel durch das Kühlrohr (5) fließt.

5. Motorsteuerungsschaltungsvorrichtung, die aufweist eine Leiterplatte (2), auf der eine Vielzahl von elektronischen Bauteilen (1) angebracht sind, und einen auf der Leiterplatte angebrachten Verbinder (3) zur Verbindung mit einer externen Schaltung,
wobei die Motorsteuerungsschaltungsvorrichtung weiter aufweist einen Harzteil (4), der aus einem aushärtenden Harz gebildet wird und den Verbinder (3) abdeckt bis auf einen Verbindungsteil davon und die Leiterplatte (2); und
ein Kühldurchlass, der in dem Harzteil (4) ausgebildet ist und einem Kühlmittel ermöglicht, durch diesen Kühldurchlass zu fließen, wodurch der Harzteil gekühlt wird.

6. Motorsteuerungsschaltungsvorrichtung, die aufweist eine Leiterplatte (2), auf der eine Vielzahl von elektronischen Bauteilen (1) angebracht sind, und einen auf der Leiterplatte angebrachten Verbinder (3) zur Verbindung mit einer externen Schaltung,
wobei die Motorsteuerungsschaltungsvorrichtung weiter aufweist einen Harzteil (4), der aus einem aushärtenden Harz gebildet wird und den Verbinder (3) abdeckt bis auf einen Verbindungsteil davon und die Leiterplatte (2); und
eine Wärmesenke aus Metall, die integral mit dem Harzteil (4) ausgebildet ist.

7. Motorsteuerungsschaltungsvorrichtung gemäß Anspruch 6, wobei die Wärmesenke (24) mit der Leiterplatte (2) unter Verwendung eines Klebemittels verbunden ist und integral mit dem Harzteil (4) ausgebildet ist.

8. Motorsteuerungsschaltungsvorrichtung gemäß Anspruch 6 oder 7, wobei auf der Wärmesenke (24) Befestigungslöcher (24c) zur Befestigung ausgebildet sind.

9. Motorsteuerungsschaltungsvorrichtung gemäß einem der vorhergehenden Ansprüche, wobei auf der Leiterplatte (2) ein thermischer Durchgang oder mehrere thermische Durchgänge ausgebildet sind zur Abstrahlung von Wärme von einer auf die andere Seite der Leiterplatte.

10. Motorsteuerungsschaltungsvorrichtung gemäß einem der vorhergehenden Ansprüche, wobei die Leiterplatte (2) aus einem flexiblen Substrat gebildet ist.

11. Motorsteuerungsschaltungsvorrichtung gemäß einem der vorhergehenden Ansprüche, wobei der Harzteil (4) derart ausgeformt ist, dass ein illuminierender elektronischer Teil von einem transparenten aushärtenden Harz umgeben ist.

## Revendications

1. Dispositif de circuit de commande d'un moteur comprenant une carte de circuit (2) sur laquelle une pluralité de parties électroniques encapsulées sont montées et un connecteur (3) monté sur ladite carte de circuit pour la connexion à un circuit externe,
dans lequel ledit dispositif de circuit de commande d'un moteur comprend également une partie en résine (4) formée d'une résine thermodurcissable et couvrant ledit connecteur (3) à l'exception d'une partie de connexion de celui-ci et ladite carte de circuit (2) ; et
un moyen de refroidissement intégralement moulé dans ladite partie en résine (4) et refroidissant ladite partie en résine (4).

2. Le dispositif de circuit de commande d'un moteur selon la revendication 1, dans lequel ledit moyen de refroidissement est un tuyau de refroidissement (5) à travers lequel circule un liquide de refroidissement.

3. Le dispositif de circuit de commande d'un moteur selon la revendication 2, dans lequel ledit tuyau de refroidissement (5) est assemblé à ladite carte de circuit (2) en utilisant un adhésif (17) et est intégralement moulé dans ladite partie en résine (4).

4. Le dispositif de circuit de commande d'un moteur selon la revendication 2 ou 3, dans lequel ledit tuyau de refroidissement (5) est disposé de telle sorte que l'eau de refroidissement du moteur circule comme ledit liquide de refroidissement à travers ledit tuyau de refroidissement (5).

5. Un dispositif de circuit de commande d'un moteur comprenant une carte de circuit (2) sur laquelle une pluralité de parties électroniques encapsulées (1) sont montées et un connecteur (3) monté sur ladite carte de circuit pour la connexion à un circuit externe,
dans lequel ledit dispositif de circuit de commande d'un moteur comprend également une partie en résine (4) formée d'une résine thermodurcissable et couvrant ledit connecteur (3) à l'exception d'une partie de connexion de celui-ci et ladite carte de circuit (2) ; et
un canal de refroidissement formé dans ladite partie en résine (4) et permettant à un liquide de refroidissement de circuler à travers ledit canal de refroidissement, ce qui refroidit ladite partie en résine.

6. Un dispositif de circuit de commande d'un moteur comprenant une carte de circuit (2) sur laquelle une pluralité de parties électroniques encapsulées (1) sont montées et un connecteur (3) monté sur ladite carte de circuit pour la connexion à un circuit externe,
dans lequel ledit dispositif de circuit de commande d'un moteur comprend également une partie en résine (4) formée d'une résine thermodurcissable et couvrant ledit connecteur (3) à l'exception d'une partie de connexion de celui-ci et ladite carte de circuit (2) ; et
un dissipateur thermique en métal intégralement moulé dans ladite partie en résine.

7. Le dispositif de circuit de commande d'un moteur selon la revendication 6, dans lequel ledit dissipateur thermique (24) est assemblé à ladite carte de circuit (2) en utilisant un adhésif et est intégralement moulé dans ladite partie en résine (4).

8. Le dispositif de circuit de commande d'un moteur selon la revendication 6 ou 7, dans lequel ledit dissipateur thermique (24) possède des trous de montage (24c) formés à l'intérieur pour permettre la fixation.

9. Le dispositif de circuit de commande d'un moteur selon l'une quelconque des revendications précédentes, dans lequel ladite carte de circuit (2) possède un ou plusieurs trous d'interconnexion thermiques formés à l'intérieur pour permettre le rayonnement de chaleur d'un côté à l'autre de ladite carte de circuit.

10. Le dispositif de circuit de commande d'un moteur selon l'une quelconque des revendications précédentes, dans lequel ladite carte de circuit (2) est formée d'un substrat flexible.

11. Le dispositif de circuit de commande d'un moteur selon l'une quelconque des revendications précédentes, dans lequel ladite partie en résine (4) est moulée de telle sorte qu'une partie électronique d'éclairage est entourée par une résine thermodurcissable transparente.
